# EUROPEAN PATENT APPLICATION

(11) **EP 1 603 165 A2**
(43) Date of publication of application: **07.12.2005**
(21) Application number: 05253352.8
(22) Date of filing: 01.06.2005
(51) Int. Cl.: H01L 27/146, H01L 31/0203

(54) **Solid state imaging device, semiconductor wafer and camera module**

(30) Priority: 01.06.2004 JP 2004163655
(71) Applicant: SHARP KABUSHIKI KAISHA, Osaka-shi, Osaka 545-8522 (JP)
(72) Inventor: Uchida, Kenji, Kasaoka-shi, Okayama 714-0044 (JP)
(74) Representative: Brown, Kenneth Richard

(57) **Abstract**

A light-permeable lid provided oppositely to a photodetector of a solid-state imaging element includes a glass substrate, and an infrared-ray shielding film formed on one side of the glass substrate. The light-permeable lid is disposed so that the side of the light-permeable lid (glass substrate) forming the infrared-ray shielding film is positioned at the opposite side of the side facing the photodetector of the solid-state imaging element. If dust mixes in the infrared-ray shielding film or dust deposits to the film, since the distance from the photodetector to dust (infrared-ray shielding film) is longer, the photodetector is less susceptible to adverse influence of the dust and occurrence of defect due to the dust can be decreased.

## Description

### BACKGROUND OF THE INVENTION

The present invention relates to a solid-state imaging device such as a CCD or C-MOS imager used when capturing an image by using a mobile phone or the like, a semiconductor wafer used in fabrication of the solid-state imaging device, and a camera module using the solid-state imaging device.

A solid-state imaging device used in a small camera built in a mobile phone or the like comprises a solid-state imaging element having a photodetector. For the purpose of protecting the photodetector, such a solid-state imaging element generally has a configuration that a light-permeable lid made of glass or the like is adhered to a semiconductor substrate by using an adhesive (see, for example, Japanese Patent Application Laid-Open Nos. 07-202152 (1995), 2001-351997 and 2003-197656). This light-permeable lid protects the surface of the photodetector from dust or flaw.

In such a solid-state imaging device, in addition to the protection of the photodetector, if it is required to shield infrared rays from the outside, it is an optimal configuration that the light-permeable lid should have an infrared-ray shielding function for the purpose of preventing the size of the device from increasing. Various methods of providing the light-permeable lid with the infrared-ray shielding function have been proposed, such as a method of absorbing infrared rays by adjusting the composition of the glass material for forming the light-permeable lid (see, for example, Japanese Patent No. 2731422), and a method of forming a dielectric multilayer film by laminating multiple layers of dielectric film differing in the refractive index on the surface of a glass plate (see, for example, Japanese Patent Application Laid-Open No. 02-213803 (1990)).

Comparing these two methods, in the latter method, presence or absence of the infrared-ray shielding function can be adjusted by presence or absence of formation of the dielectric multilayer film on the glass plate, and the glass plate is not wasted. Thus, the latter method is more rational.

In the latter method, when forming the dielectric multilayer film on one side of the glass plate, a physical deposition method may be used, such as a vapor deposition method or a sputtering method. Therefore, when forming a dielectric multilayer film, dust particles may get in. Besides, since the surface after forming film lacks in smoothness as compared with glass surface, and dust is more likely to deposit. In the light-permeable substrate (glass plate) forming the dielectric multilayer film for shielding infrared rays, hence, it is highly possible that dust may be mixed in the dielectric multilayer film or dust may be adhered to the film.

When using the light-permeable substrate with dielectric multilayer film high in possibility of dust deposit in a solid-state imaging device, presence of dust at position near the photodetector of the solid-state imaging element may be cause of defect, and hence a proper measure to avoid an influence of dust is required in consideration of possibility of dust deposit.

Such a problem of defect due to dust entry or dust deposit is not limited to a case of dielectric multilayer film for shielding infrared rays, but may also occur in a light reflection preventive film, a transparent conductive film or a protective film formed on a light-permeable substrate by a physical deposition method. In other films than shown herein, a similar problem of defect due to dust entry or dust deposit may occur, and the film forming method is not limited to a physical deposition method, but the same problem of defect due to dust entry or dust deposit may also occur in the film formed by other chemical deposition method.

### BRIEF SUMMARY OF THE INVENTION

The invention has been devised in the light of the above circumstances, and it is hence a primary object thereof to provide a solid-state imaging device, a semiconductor wafer and a camera module capable of decreasing occurrence of defects due to dust entry or dust deposit, by positioning a film forming side of a light-permeable lid or a light-permeable plate member at opposite side of a photodetector.

The solid-state imaging device of the invention comprises a solid-state imaging element having a photodetector, and a light-permeable lid provided at the light incident side of the photodetector and having a film formed on one side thereof, in which the light-permeable lid is disposed so that the one side of the light-permeable lid is positioned at the opposite side of the side facing the photodetector. In an optical system applied in a solid-state imaging device, the shadow of a dust particle at the position of the light-permeable lid is projected on the photodetector surface of the solid-state imaging element. However, in the case of a dust particle of same size, the influence of dust particle shadow on the photodetector surface of the solid-state imaging element is smaller as the position of dust particle is apart from the solid-state imaging element. In the invention, since the light-permeable lid is disposed so that the surface of the light-permeable lid having the film may be at the opposite side of the side facing the photodetector, as compared with the case of forming this surface at the side facing the photodetector, the distance of the photodetector and film is longer, and if dust mixes in the film or dust deposits to the film, the influence of dust is small and defect occurs hardly.

In the solid-state imaging device of the invention, the film is a film selected from the group consisting of an infrared-ray shielding film, a light reflection preventive film, a transparent conductive film and a protective film. The invention decreases the problems of occurrence of defect due to dust entry or dust deposit in the solid-state imaging device having an infrared-ray shielding film, a light reflection preventive film, a transparent conductive film or a protective film in the light-permeable lid.

The semiconductor wafer of the invention comprises plural photodetectors, and a light-permeable plate member provided at the light incident side of the photodetectors and having a film formed on one side thereof, in which the light-permeable plate member is disposed so that the one side of the light-permeable plate member is positioned at the opposite side of the side facing the photodetectors. In the semiconductor wafer for solid-state imaging device of the invention, since the light-permeable plate member having the film is disposed so that the surface of the light-permeable plate member having the film is positioned at the opposite side of the side facing the photodetectors, the distance of the photodetectors and film is longer, and if dust mixes in the film or dust deposits to the film, the influence of dust is small and defect occurs hardly.

The semiconductor wafer of the invention comprises plural photodetectors, and plural light-permeable lids each provided at the light incident side of each one of the plural photodetectors and having a film formed on one side thereof, in which each light-permeable lid is disposed so that the one side of the light-permeable lid is positioned at the opposite side of the side facing each one of the photodetectors. In the semiconductor wafer for solid-state imaging device of the invention, since each light-permeable lid having the film is disposed so that the surface of each light-permeable lid having the film is positioned at the opposite side of the side facing each photodetector, the distance of the photodetector and film is longer, and if dust mixes in the film or dust deposits to the film, the influence of dust is small and defect occurs hardly.

In the semiconductor wafer of the invention, the film is a film selected from the group consisting of an infrared-ray shielding film, a light reflection preventive film, a transparent conductive film and a protective film. The invention decreases the problems of occurrence of defect due to dust entry or dust deposit in the semiconductor wafer having an infrared-ray shielding film, a light reflection preventive film, a transparent conductive film or a protective film in the light-permeable plate member or the light-permeable lid.

The camera module of the invention comprises a lens, and a solid-state imaging device of the invention having the film disposed opposite to the lens. The invention incorporates the solid-state imaging device of the invention, and decreases the problems of occurrence of defect due to dust entry or dust deposit to the film. More specifically, for example, the configuration comprises a lens, a lens holder for holding the lens, and a solid-state imaging device having the film facing the lens and disposed inside the lens holder. Another configuration comprises a lens, a lens holder for holding the lens, and a cover member having the lens holder and surrounding the solid-state imaging device of the invention, in which the film is formed opposite to the lens, and the lens holder is attached to the cover member.

In the solid-state imaging device of the invention, since the surface of the light-permeable lid forming the film is at opposite side to the photodetector, it hardly has influences of dust mixing in the film or dust depositing to the film, and occurrence of defect due to dust can be considerably decreased.

In the semiconductor wafer of the invention, since the surface of the light-permeable plate member or light-permeable lid forming the film is at opposite side to the photodetector, it hardly has influences of dust mixing in the film or dust depositing to the film, and occurrence of defect due to dust can be considerably decreased.

In the camera module of the invention, since the solid-state imaging device of the invention is incorporated, it hardly has influences of dust, and occurrence of defect due to dust can be considerably decreased.

In the solid-state imaging device and semiconductor wafer of the invention, when an infrared-ray shielding film, a light reflection preventive film, a transparent conductive film or a protective film is provided as the film, it hardly has influences of dust mixing in the film or dust depositing to the film, and occurrence of defect due to dust can be considerably decreased.

The above and further objects and features of the invention will more fully be apparent from the following detailed description with accompanying drawings.

### BRIEF DESCRIPTION OF THE SEVERAL VIEWS OF THE DRAWINGS

FIG. 1 is a sectional view of the configuration of a solid-state imaging device of the invention;
FIG. 2A is a plan view of an example of a semiconductor wafer of the invention;
FIG. 2B is a sectional view of an example of the semiconductor wafer of the invention;
FIG. 3A is a plan view of another example of the semiconductor wafer of the invention;
FIG. 3B is a sectional view of another example of the semiconductor wafer of the invention; and
FIG. 4 is a sectional view of the configuration of a camera module of the invention.

### DETAILED DESCRIPTION OF THE INVENTION

Referring now to the drawings, preferred embodiments of the invention will be specifically described below. It must be noted however that the invention is not limited to the illustrated embodiments alone.

### (First Embodiment)

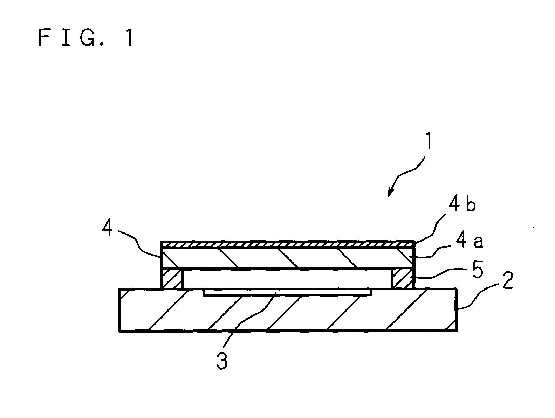

FIG. 1 is a sectional view of the configuration of a solid-state imaging device of the invention. A solid-state imaging device 1 comprises a solid-state imaging element 2 formed on a semiconductor substrate in a rectangular shape in a plan view, a photodetector 3 formed on one side of the solid-state imaging element 2, a light-permeable lid 4 disposed opposite to the photodetector 3, and an adhesive section 5 formed on one side of the solid-state imaging element 2 in a region excluding the photodetector 3, for adhering the light-permeable lid 4 and solid-state imaging element 2. The solid-state imaging device 1 receives light from outside through the light-permeable lid 4, and detects by a photodetector element (effective pixel) disposed in the photodetector 3 of the solid-state imaging element 2. Although not shown, a micro lens is disposed on the surface of the photodetector 3, and incident light is focused on the photodetector element of each pixel.

The light-permeable lid 4 includes a glass substrate 4a, and an infrared-ray shielding film 4b formed on one side of the glass substrate 4a, and the light-permeable lid 4 is disposed so that the side of the light-permeable lid 4 (glass substrate 4a) forming the infrared-ray shielding film 4b is positioned at the opposite side of the side facing the photodetector 3 of the solid-state imaging element 2. More specifically, the light-permeable lid 4 is disposed so that the face, on which the infrared-ray shielding film 4b of the light-permeable lid 4 (glass substrate 4a) is formed, is opposite to the side facing the photodetector 3 of the solid-state imaging element 2. The infrared-ray shielding film 4b includes, for example, a dielectric multilayer film laminating alternately multiple layers consisting of a high refractive index layer composed of titanium oxide, zirconium oxide or zinc sulfide, and a low refractive index layer composed of magnesium fluoride, calcium fluoride or silicon dioxide, and it is designed to shield infrared light selectively by making use of light interference. The light-permeable lid 4 has a protective function of protecting the photodetector 3 from outside by covering the photodetector 3, and an infrared-ray shielding function of preventing the infrared light contained in outside light from entering the photodetector 3 by means of the infrared-ray shielding film 4b.

The outer periphery of a space formed between the oppositely disposed photodetector 3 and light-permeable lid 4 is adhered by means of the adhesive section 5. By thus forming this space, invasion of dust and humidity into the surface of the photodetector 3, and formation of scratch or other flaw on the surface of the photodetector 3 can be suppressed, and occurrence of defects in the photodetector 3 can be prevented.

In the first embodiment, since the light-permeable lid 4 is disposed so that the infrared-ray shielding film 4b is positioned at the opposite side of the photodetector 3, if dust mixes into the infrared-ray shielding film 4b or dust deposits to the infrared-ray shielding film 4b, as compared with the case of forming the infrared-ray shielding film 4b at the side facing the photodetector 3, the distance from the photodetector 3 to dust (infrared-ray shielding film 4b) is longer, the photodetector 3 is less susceptible to influence of the dust and occurrence of defect by the dust can be decreased.

A semiconductor wafer of the invention for fabricating the solid-state imaging device 1 as mentioned above will be described as second and third embodiments.

### (Second Embodiment)

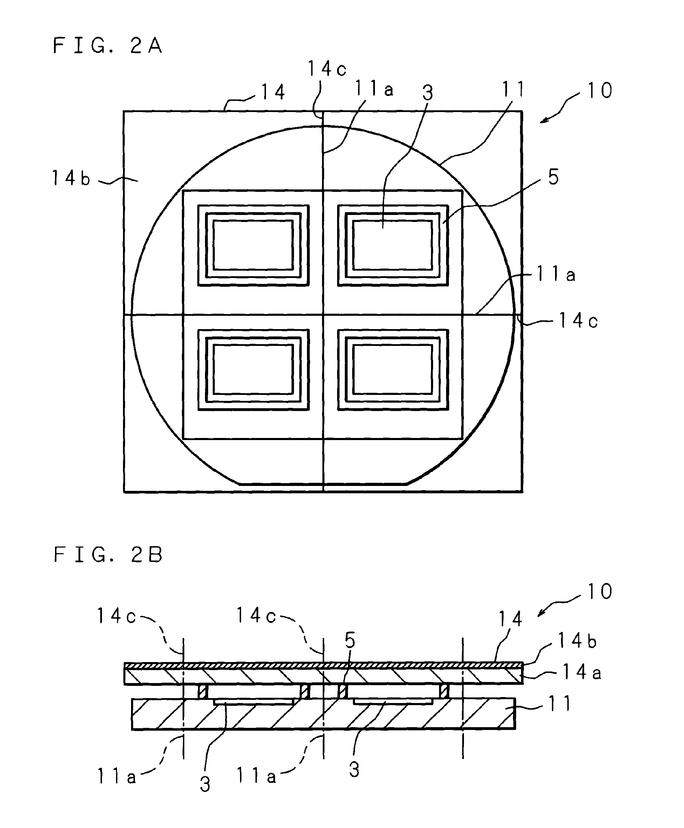

FIGS. 2A and 2B show an example of a semiconductor wafer of the invention, and FIG. 2A is its plan view and FIG. 2B is its sectional view. A semiconductor wafer 10 comprises a semiconductor substrate 11 having patterns of plural photodetectors 3 formed on one side, and a light-permeable plate member 14 adhered thereon by adhesive sections 5. Although not shown, a micro lens is disposed on the surface of the photodetectors 3, and incident light is focused on the photodetector element of each pixel.

The light-permeable plate member 14 includes a glass substrate 14a, and an infrared-ray shielding film 14b formed on one side of the glass substrate 14a, and the light-permeable plate member 14 is disposed so that the side of the light-permeable plate member 14 (glass substrate 14a) forming the infrared-ray shielding film 14b is positioned at the opposite side of the side facing the photodetectors 3 of the semiconductor substrate 11. That is, the light-permeable plate member 14 is disposed so that the side of the light-permeable plate member 14 (glass substrate 14a) forming the infrared-ray shielding film 14b is positioned at the opposite side of the side facing the photodetectors 3 of the semiconductor substrate 11. The infrared-ray shielding film 14b has the same configuration and function as the infrared-ray shielding film 4b mentioned above.

On one side of the semiconductor substrate 11, patterns of plural adhesive sections 5 are formed in a region excluding the photodetectors 3, and by these adhesive sections 5, the light-permeable plate member 14 is adhered to the semiconductor substrate 11, so that a space is formed between the photodetectors 3 and the light-permeable plate member 14.

Such a semiconductor wafer 10 is manufactured in the following manner. First, on the surface of the glass substrate 14a, a high refractive index layer and a low refractive index layer are alternately laminated by a physical deposition method such as a vacuum deposition method or a sputtering method, and an infrared-ray shielding film 14b of a dielectric multilayer film is formed, and a light-permeable plate member 14 is obtained. On the surface of the semiconductor substrate 11 forming plural photodetectors 3, an adhesive agent mixing a photosensitive adhesive (for example, ultraviolet (UV) curing resin as acrylic resin) and a thermosetting resin (for example, epoxy resin) is uniformly applied, and the adhesive agent is patterned by known photolithography technology, and an adhesive section 5 is formed in each solid-state imaging element. The light-permeable plate member 14 is properly disposed on the patterned adhesive sections 5, and adhered to the adhesive sections 5 (semiconductor substrate 11) by thermosetting.

Using such a semiconductor wafer 10, the solid-state imaging deice is manufactured in the following procedure. The light-permeable plate member 14 adhered to the semiconductor substrate 11 is diced along division lines 14c, and plural light-permeable lids are fabricated. The semiconductor substrate 11 to which plural light-permeable lids are adhered is diced along division lines 11a, and a solid-state imaging device as shown in FIG. 1 is manufactured.

In the second embodiment, since the light-permeable plate member 14 is disposed so that the infrared-ray shielding film 14b is positioned at the opposite side of the photodetectors 3, if dust mixes into the infrared-ray shielding film 14b or dust deposits to the infrared-ray shielding film 14b, as compared with the case of forming the infrared-ray shielding film 14b at the side facing the photodetectors 3, the distance from the photodetectors 3 to dust (infrared-ray shielding film 14b) is longer, the photodetector 3 is less susceptible to influence of the dust and occurrence defect by the dust can be decreased.

### (Third Embodiment)

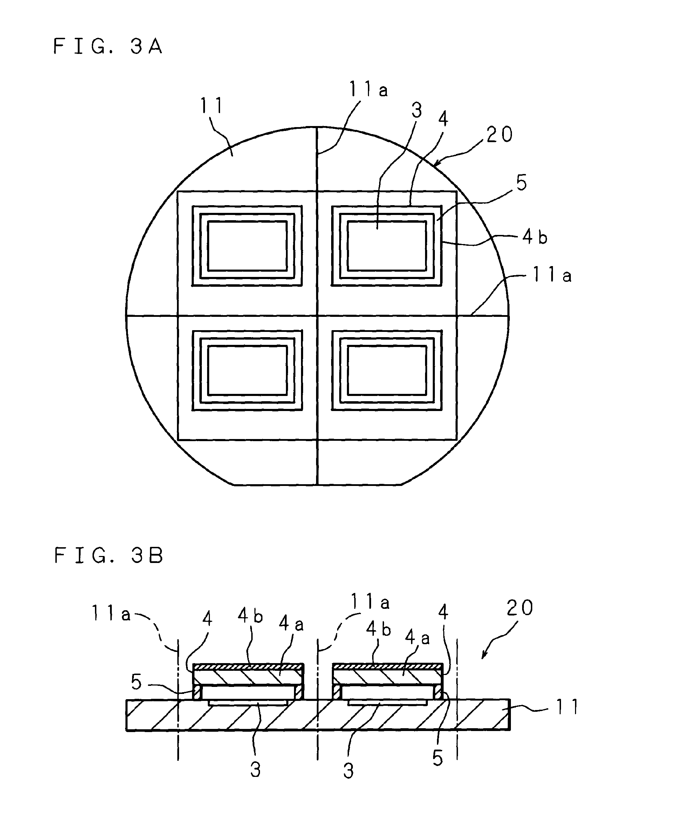

FIGS. 3A and 3B show another example of the semiconductor wafer of the invention, and FIG. 3A is its plan view and FIG. 3B is its sectional view. A semiconductor wafer 20 comprises a semiconductor substrate 11 having patterns of plural photodetectors 3 formed on one side, and plural individual pieces of light-permeable lid 4 adhered thereon by an adhesive section 5. Although not shown, a micro lens is disposed on the surface of the photodetectors 3, and incident light is focused on the photodetector element of each pixel.

Each light-permeable lid 4 is identical with the light-permeable lid 4 of the first embodiment, and each light-permeable lid 4 is disposed so that the side of each light-permeable lid 4 (each glass substrate 4a) forming the infrared-ray shielding film 4b is positioned at the opposite side of the side facing each photodetector 3 of the semiconductor substrate 11. That is, each light-permeable lid 4 is disposed so that the side of each light-permeable lid 4 (each glass substrate 4a) forming the infrared-ray shielding film 4b is positioned at the opposite side of the side facing each photodetector 3 of the semiconductor substrate 11. On one side of the semiconductor substrate 11, patterns of plural adhesive sections 5 are formed in a region excluding the photodetectors 3, and by these adhesive sections 5, the plural light-permeable lids 4 are adhered to the semiconductor substrate 11, so that a space is formed between the mutually opposing photodetectors 3 and the light-permeable lids 4.

Such a semiconductor wafer 20 is manufactured in the following manner. First, on the surface of the glass substrate, a high refractive index layer and a low refractive index layer are alternately laminated by a physical deposition method such as a vacuum deposition method or a sputtering method, and an infrared-ray shielding film of a dielectric multilayer film is formed, and by dicing and dividing (into individual pieces) along specified division lines, plural light-permeable lids 4 are obtained. On the other hand, on the surface of the semiconductor substrate 11 forming plural photodetectors 3, an adhesive agent mixing a photosensitive adhesive (for example, ultraviolet (UV) curing resin as acrylic resin) and a thermosetting resin (for example, epoxy resin) is uniformly applied, and the adhesive agent is patterned by known photolithography technology, and an adhesive section 5 is formed in each solid-state imaging element. Each light-permeable lid 4 is positioned, and disposed on the patterned adhesive sections 5, and adhered to the adhesive sections 5 (semiconductor substrate 11) by thermosetting.

Using such a semiconductor wafer 20, a solid-state imaging device as shown in FIG. 1 is manufactured by dicing the semiconductor substrate 11 adhering plural light-permeable lids 4 along division lines 11a.

In the third embodiment, since each light-permeable lid 4 is disposed so that each infrared-ray shielding film 4b is positioned at the opposite side of each photodetector 3, if dust mixes into the infrared-ray shielding film 4b or dust deposits to the infrared-ray shielding film 4b, as compared with the case of forming the infrared-ray shielding film 4b at the side facing each photodetector 3, the distance from the photodetector 3 to dust (infrared-ray shielding film 4b) is longer, the photodetector 3 is less susceptible to influence of the dust and occurrence of defect by the dust can be decreased.

In the second and third embodiments, adhesive sections are patterned and formed on the semiconductor substrate, but adhesive sections may be first patterned and formed on the light-permeable plate member or the light-permeable lid, and then they may be adhered to the semiconductor substrate.

### (Fourth Embodiment)

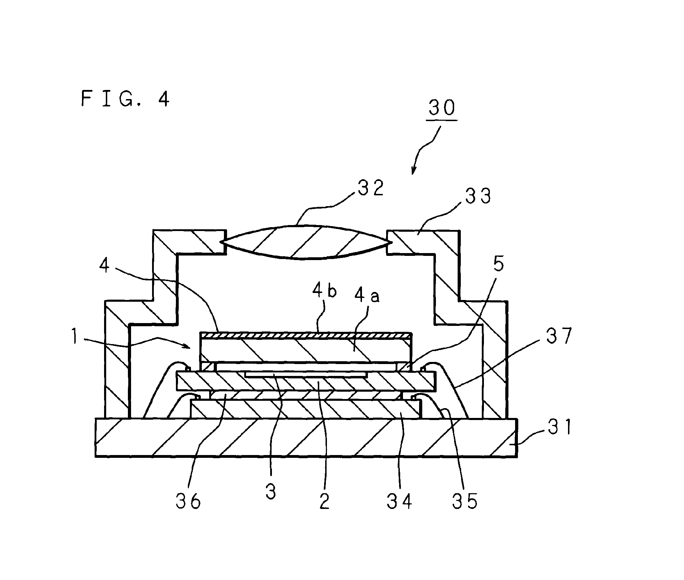

FIG. 4 is a sectional view of the configuration of a camera module of the invention. A camera module 30 comprises a wiring board 31 such as a printed board or a ceramic substrate, and a lens 32 for receiving light from outside and a lens holder 33 for holding the lens 32, being mounted thereon. A digital signal processor (DSP) 34 is mounted on the wiring board 31. The DSP 34 controls the operation of the solid-state imaging device 1 (solid-state imaging element 2), and functions as an image processor for generating a signal necessary for an optical device by properly processing the output signal from the solid-state imaging device 1 (solid-state imaging element 2). The structure in FIG. 4 shows a stacked structure of the DSP 34 and solid-state imaging device 1 laminated on the wiring board 31, but the DSP 34 and solid-state imaging device 1 may be arranged side by side on the same side of the wiring board 31, or the solid-state imaging device 1 may be disposed at the lens 32 side of the wiring board 31, and the DSP 34 may be disposed at the rear side. In FIG. 4, further, the portion for holding the lens 32 and the portion enclosing the solid-state imaging device 1 are composed of the lens holder 33 of the same material, but the portion for holding the lens 32 (lens holder) and the portion enclosing the solid-state imaging device 1 (cover member) may be composed of different members.

Each connection terminal of the DSP 34 and the wiring (not shown) formed on the wiring board 31 are electrically connected by means of a bonding wire 35. On the DSP 34, the solid-state imaging device 1 (solid-state imaging element 2) of the invention is mounted via a spacer 36. Each connection terminal of the solid-state imaging element 2 and the wiring (not shown) formed on the wiring board 31 are electrically connected by means of a bonding wire 37. The structure of the solid-state imaging device 1 in the fourth embodiment and the structure of the solid-state imaging device 1 in the first embodiment (FIG. 1) are identical, and same parts are identified with same reference numerals.

In the illustrated examples, the infrared-ray shielding film is provided on the light-permeable lid or light-permeable plate member, but the film to be provided is not 1 limited to the infrared-ray shielding film. Other films may be formed, such as a light reflection preventive film, a transparent conductive film or a protective film, and as far as the light-permeable lid or light-permeable plate member is disposed so that the film forming side may be positioned at opposite side of the side facing the photodetector, if dust mixes in the film or dust deposits to the film, influences of dust can be suppressed, and occurrence of defect can be decreased, so that the same effects can be obtained.

## Claims

1. A solid-state imaging device (1), **characterized by** comprising:
a solid-state imaging element (2) having a photodetector (3); and
a light-permeable lid (4) provided at a light incident side of said photodetector (3) and having a film (4b) formed on one side thereof,
wherein said light-permeable lid (4) is disposed so that said one side of said light-permeable lid (4) is positioned at an opposite side of a side facing said photodetector (3).

2. The solid-state imaging device of claim 1, wherein
said film (4b) is a film selected from the group consisting of an infrared-ray shielding film, a light reflection preventive film, a transparent conductive film and a protective film.

3. A semiconductor wafer (10), **characterized by** comprising:
plural photodetectors (3); and
a light-permeable plate member (14) provided at a light incident side of the photodetectors (3) and having a film (14b) formed on one side thereof,
wherein said light-permeable plate member (14) is disposed so that said one side of said light-permeable plate member (14) is positioned at an opposite side of a side facing said photodetectors (3).

4. A semiconductor wafer (20), **characterized by** comprising:
plural photodetectors (3); and
plural light-permeable lids (4) each provided at a light incident side of each one of the plural photodetectors (3) and having a film (4b) formed on one side thereof,
wherein said light-permeable lids (4) are disposed so that said one side of each light-permeable lid (4) is positioned at an opposite side of a side facing each one of said photodetectors (3).

5. The semiconductor wafer of claim 3 or 4, wherein
said film (14b or 4b) is a film selected from the group consisting of an infrared-ray shielding film, a light reflection preventive film, a transparent conductive film and a protective film.

6. A camera module (30), **characterized by** comprising:
a lens (32); and
the solid-state imaging device of claim 1 or 2 having said film (4b) disposed opposite to said lens (32).
